# EUROPÄISCHE PATENTANMELDUNG

(11) **EP 4 456 429 A1**
(43) Veröffentlichungstag der Anmeldung: **30.10.2024**
(21) Anmeldenummer: 23170537.7
(22) Anmeldetag: 28.04.2023
(51) Int. Cl.: H03K 17/97, H02G 3/08, H05B 47/00

(54) **FUNKTIONSMODUL ZUR BESTIMMUNG DER LEISTUNGSAUFNAHME EINER ANGESCHLOSSENEN LAST**

(71) Anmelder: Insta GmbH, 58509 Lüdenscheid (DE)
(72) Erfinder: Becker-Hennecke, Ralph, 58239 Schwerte (DE)
(74) Vertreter: Fobbe, Tobias

(57) **Zusammenfassung**

Zu dem Zweck, ein Funktionsmodul F zum Einbau in eine Installationsdose D mit einem manuell zu betätigenden Schaltgerät S vorzuschlagen, wobei die Leistungsaufnahme beziehungsweise der Energiebedarf von an das Funktionsmodul F angeschlossenen Verbrauchern unterputz ermittelt werden, wobei weder zusätzliche Kosten noch ein zusätzlicher Bauraumbedarf anfallen, wird ein Funktionsmodul F vorgestellt, das durch die Betätigung eines an dem Schaltgerät S angeschlossenen Betätigungselementes B eines Oberteils O beeinflussbar ist, wobei das Funktionsmodul F zumindest eine Schnittstelle aufweist, mittels welcher zumindest ein Aktor entsprechend einer Betätigung des Betätigungselements B ansteuerbar ist, wobei an dem Schaltgerät S mindestens ein Magnet M angeordnet ist, welcher bei Betätigung des Betätigungselementes B seine Position ändert, und wobei das Funktionsmodul F einen Sensor H zur Erfassung des Magnetfeldes aufweist, so dass die Änderung des Magnetfeldes bei Betätigung des Betätigungselementes B detektiert wird, wobei das Funktionsmodul F eine Auswerteeinheit zur Auswertung der Magnetfeldänderung aufweist. Das Funktionsmodul F zeichnet sich dadurch aus, dass das Funktionsmodul F ein Gehäuse G aufweist, welches eine Schnittstelle mit Anschlüssen C aufweist, wobei der Sensor H zur Erfassung des Magnetfeldes zur induktiven Erfassung von Strom und/oder Spannung unmittelbar angrenzend zu den Anschlüssen C angeordnet ist.

## Beschreibung

Die Erfindung betrifft ein Funktionsmodul zum Einbau in eine Installationsdose mit einem manuell zu betätigenden Schaltgerät der Gebäudeinstallationstechnik, welches Funktionsmodul durch die Betätigung eines an dem Schaltgerät angeschlossenen Betätigungselementes eines Oberteils des Schaltgerätes beeinflussbar ist, wobei das Funktionsmodul zumindest eine Schnittstelle aufweist, mittels welcher zumindest ein Aktor entsprechend einer Betätigung des Betätigungselements ansteuerbar ist, wobei an dem Schaltgerät mindestens ein Magnet angeordnet ist, welcher bei Betätigung des Betätigungselementes seine Position ändert, und dass das Funktionsmodul einen Sensor zur Erfassung des Magnetfeldes aufweist, so dass die Änderung des Magnetfeldes bei Betätigung des Betätigungselementes detektiert wird, wobei das Funktionsmodul eine Auswerteeinheit zur Auswertung der Magnetfeldänderung aufweist, die dazu eingerichtet ist, in Abhängigkeit der sensierten Magnetfeldänderung zu identifizieren, um welche Schaltgeräteart es sich bei dem Schaltgerät handelt, welche Identifikation in die funktionsmodulseitige Ansteuerung des Aktors einfließt.

Die Erfindung betrifft ferner eine Anordnung umfassend ein solches Funktionsmodul und ein Schaltgerät, insbesondere einen Schalter oder einen Taster.

Aus AT 525 242 B1 ist ein gattungsgemäßes Funktionsmodul zum Einbau in eine Installationsdose mit einem manuell zu betätigenden Schaltgerät der Gebäudeinstallationstechnik bekannt geworden. Ein solches Funktionsmodul ist durch die Betätigung eines an dem Schaltgerät angeschlossenen Betätigungselementes eines Oberteils des Schaltgerätes beeinflussbar, beispielsweise um Lampen zu schalten, zu dimmen oder um Jalousien zu steuern, und zwar auch fernbedienbar, beispielsweise via Endgerät. Hierzu weist das Funktionsmodul zumindest eine Schnittstelle auf, mittels welcher zumindest ein Aktor entsprechend einer Betätigung des Betätigungselements ansteuerbar ist, wobei an dem Schaltgerät mindestens ein Magnet angeordnet ist, welcher bei Betätigung des Betätigungselementes seine Position ändert. Ferner weist das Funktionsmodul einen Sensor zur Erfassung des Magnetfeldes auf, so dass die Änderung des Magnetfeldes bei Betätigung des Betätigungselementes detektiert wird. Es versteht sich, dass das Funktionsmodul über ein Endgerät, insbesondere ein mobiles Endgerät, beeinflussbar ist, um auf komfortable Weise bedient werden zu können. Ein solches, vorbekanntes Funktionsmodul umfasst zudem eine Auswerteeinheit zur Auswertung der Magnetfeldänderung, die dazu eingerichtet ist, in Abhängigkeit der sensierten Magnetfeldänderung zu identifizieren, um welche Schaltgeräteart es sich bei dem Schaltgerät handelt, welche Identifikation in die funktionsmodulseitige Ansteuerung des Aktors einfließt, so dass ein Austausch von Schaltern durch Taster vermieden wird. So erfordert das Dimmen einer Lampe mit einem Funktionsmodul beispielsweise eine spezifische Ansteuerung, je nachdem, ob das zugrundeliegende Schaltgerät ein Taster oder ein Schalter ist. Daher ist die Identifikation der Schaltgeräteart durch die Auswerteeinheit ein weiterer Vorteil eines solchen Funktionsmoduls.

Durch ein solches, vorbekanntes Funktionsmodul kann der Installationsaufwand mit Blick auf den zu leistenden Verkabelungsaufwand, wie er bei herkömmlichen Funktionsmodulen ohne Sensierung der Magnetfeldänderung erforderlich ist - hierbei werden Kabel zwischen Schaltgerät und Funktionsmodul (nachfolgend fliegende Verkabelung genannt) angeschlossen, um die Betätigung elektrisch zu übermitteln - signifikant verringert werden, da Funktionsmodul und Schaltgerät magnetisch miteinander kommunizieren; ein elektrischer Anschluss des Funktionsmoduls an das Schaltgerät ist mithin obsolet geworden.

Problematisch bei solchen vorbekannten gattungsgemäßen Funktionsmodulen ist jedoch, dass diese keinerlei Funktionalität bieten, die Leistungsaufnahme beziehungsweise den Energiebedarf von an das Funktionsmodul angeschlossenen Verbrauchern zu ermitteln, beispielsweise von Leuchten oder - wenn das Funktionsmodul beispielsweise zum Schalten von Lasten über ein Relais genutzt wird - beliebigen anderen Lasten.

Grundsätzlich bekannt sind Leistungsmesser, die beispielsweise als Zwischensteckerlösung (Aufputz) genutzt werden können. Diese sind jedoch optisch auffällig, bauraumbeanspruchend und nicht hinter ein Schaltgerät montierbar; insbesondere nicht in Installationsdosen.

Ausgehend von diesem diskutierten Stand der Technik liegt der Erfindung die Aufgabe zugrunde, ein Funktionsmodul zum Einbau in eine Installationsdose mit einem manuell zu betätigenden Schaltgerät vorzuschlagen, wobei die vorstehend genannten Nachteile vermieden sind. Insbesondere soll die Leistungsaufnahme beziehungsweise der Energiebedarf von an das Funktionsmodul angeschlossenen Verbrauchern unterputz ermittelt werden, wobei weder zusätzliche Kosten noch ein zusätzlicher Bauraumbedarf anfallen sollen.

Gelöst wird diese Aufgabe durch ein Funktionsmodul, das ein Gehäuse aufweist, welches eine Schnittstelle mit Anschlüssen aufweist, wobei der Sensor zur Erfassung des Magnetfeldes zur induktiven Erfassung von Strom und/oder Spannung unmittelbar angrenzend zu den Anschlüssen angeordnet ist.

Der Kerngedanke der Erfindung besteht darin, dass das Funktionsmodul ein Gehäuse aufweist, welches eine Schnittstelle mit Anschlüssen aufweist. Diese Anschlüsse dienen beispielsweise zum Anschluss an eine Energieversorgung, insbesondere an einen Außenleiter und einen Neutralleiter. Ein weiterer Anschluss dient beispielsweise dazu, eine Steuerleitung an das Funktionsmodul anzuschließen, so dass ein Verfahren einer Jalousie (wobei hier zwei Steuerleitungen erforderlich sind) oder das Dimmen einer Lampe (eine Steuerleitung) ermöglicht wird. Erfindungsgemäß wird sich auf intelligente Art und Weise zu Nutze gemacht, dass der ohnehin vorhandene Sensor zur Erfassung des Magnetfeldes (der zur Erfassung der Betätigung eines, einen Magneten aufweisenden, Betätigungselementes eines Schaltgerätes gedacht ist) zur induktiven Erfassung von Strom und/oder Spannung unmittelbar angrenzend zu den Anschlüssen angeordnet ist. Durch die räumliche Nähe zwischen Sensor und Anschlüssen, insbesondere der Anschluss des Außen- und/oder Neutralleiters, kann der Strom und/oder die Spannung induktiv erfasst werden, die zu der Leistungsaufnahme beziehungsweise zu dem Energiebedarf des an das Funktionsmodul angeschlossenen Verbrauchers korrespondieren. Hierdurch kann auf besonders vorteilhafte Weise ohne zusätzlichen Bauraum- und Kostenbedarf eine Bestimmung der Leistungsaufnahme beziehungsweise des Energiebedarfs erreicht werden.

Gemäß einer besonders bevorzugten Ausgestaltung wird durch das erfindungsgemäße Funktionsmodul vorteilhafterweise der Installationsaufwand des Funktionsmoduls hinter ein Schaltgerät signifikant verringert, indem das Gehäuse des Funktionsmoduls mindestens eine, regelmäßig zwei, Ausnehmung(en) aufweist, die mit Vorsprüngen des Schaltgerätes in Eingriff gestellt ist/sind, so dass das erfindungsgemäße Funktionsmodul an dem Schaltgerät gelagert angeschlossen ist. Mithin ist ein gemeinsames Einsetzen, also: Funktionsmodul und Schaltgerät zusammen, ermöglicht. Hierdurch wird der Installationsaufwand spürbar abgesenkt, da das Herausfallen gattungsgemäßer Funktionsmodule (beispielsweise da das unter mechanischen Spannung stehende Kabelgut in der Installationsdose eine rückstellende Kraft erzeugt) effektiv vermieden wird, indem das erfindungsgemäßes Funktionsmodul, das mit Vorsprüngen des Schaltgerätes in Eingriff gestellt ist, zusammen in einem Schritt direkt in der Installationsdose festgelegt werden.

In einer besonders bevorzugten Ausgestaltung des erfindungsgemäßen Funktionsmoduls ist auf der Leiterplatte im Bereich außerhalb der Ausnehmung ein Relais und/oder ein Dimmer lokalisiert. Relais und/oder Dimmer beanspruchen regelmäßig eine besondere Höhe. Durch die vorbeschriebene Anordnung des Relais und/oder Dimmers im Bereich außerhalb der Ausnehmung des Gehäuses werden die erfindungsgemäß erreichten Bauraumvorteile, insbesondere bezüglich der effektiven Einbautiefe des Funktionsmoduls hinter ein Schaltgerät, in besonderer Weise ausgenutzt.

In einer weiteren bevorzugten Ausgestaltung des erfindungsgemäßen Funktionsmoduls ist auf der Leiterplatte im Bereich der Ausnehmung der Sensor zur Erfassung des Magnetfeldes und/oder eine Funksende- oder Empfangseinheit lokalisiert. Auf diese Art und Weise wird Platz auf der Leiterplatte geschaffen, um gewisse Aufbauhöhe beanspruchende Bauteile wie Anschlüsse, Relais oder Dimmer in Bereichen ohne Ausnehmung des Gehäuses anzuordnen (in denen ein gewisser Teil ihrer Aufbauhöhe gewissermaßen zwischen die Vorsprüngen des Schaltgerätes versenkend eintaucht), während der Sensor zur Erfassung des Magnetfeldes und/oder eine Funksende- oder Empfangseinheit (als Bauteile geringer Aufbauhöhe) im Bereich der Ausnehmung angeordnet werden.

Gemäß einer besonders bevorzugten Ausgestaltung des erfindungsgemäßen Funktionsmoduls ist die mindestens eine Ausnehmung mindestens teilweise komplementär zu den Vorsprüngen des Schaltgerätes. Eine solche Ausgestaltung erlaubt es, das Volumen des Funktionsmoduls zu maximieren und den Einbautiefenverlust auf besonders ausgeprägte Weise zu minimieren.

In einer Ausgestaltung, die für den Installateur besonders praktisch handzuhaben ist, weist das erfindungsgemäße Funktionsmodul abgeflachte Seiten auf.

Gemäß einer besonders bevorzugten Ausgestaltung des erfindungsgemäßen Funktionsmoduls macht die mindestens eine Ausnehmung bezüglich der Grundfläche des Funktionsmoduls in einer Draufsicht weniger als 50%, insb. weniger als 30%, der Grundfläche aus. Hierdurch wird es durch das Beschränken der Ausnehmung bezüglich der Grundfläche des Funktionsmoduls ermöglicht, dass die Ausnehmungen dezidiert für das vorzugsweise komplementäre Aufnehmen beziehungsweise Ineingriffstellen von Schraubdomen geschaffen sind, so dass nicht viel Volumen des Funktionsmoduls geopfert wird, aber aufgrund des Ineingriffstellens der effektive Bauraumbedarf abgesenkt und die Positionsfixierung des Funktionsmoduls sichergestellt wird.

In einer erfindungsgemäßen Ausgestaltung, die für den Installateur besonders einfach handzuhaben ist, insbesondere in die Installationsdose einzusetzen ist, liegt der Krümmungsradius der Grundfläche des Funktionsmoduls im Bereich von 18 bis 27 mm.

In einer erfindungsgemäßen Ausgestaltung, die sich durch eine für viele Installationsdosen geeignete Geometrie auszeichnet, liegt der effektive Durchmesser der Grundfläche des Funktionsmoduls im Bereich von 32 bis 52 mm, insbesondere im Bereich von 38 mm bis 46 mm.

Gemäß einer ganz besonders bevorzugten Ausgestaltung des erfindungsgemäßen Funktionsmoduls ist die Ausnehmung als Absatz mit einer Höhe ausgeführt, wobei die Höhe der Ausnehmung maximal 10 mm, insbesondere weniger als 8 mm, beträgt. Hierdurch wird es auf intelligente Art und Weise ermöglicht, eine möglichst große Leiterplatte für das Funktionsmodul vorzusehen, indem die Ausnehmungen nicht zu Lasten der Größe der Leiterplatte gehen. Insofern wird es ermöglicht, die erforderlichen elektronischen Bauteile auf der Leiterplatte unterzubringen, wobei bezüglich eines (im Stand der Technik weit verbreiteten) Gehäuses mit konstanter Höhe (also: ohne Absatz) durch die Vermeidung von mindestens zwei Anschlüssen, aufgrund des Verzichtes auf eine fliegende Verkabelung, nicht genutzte Gehäusevolumina durch die erfindungsgemäßen Ausnehmungen beansprucht werden. Dabei wird erfindungsgemäß ausgenutzt, dass durch die erfindungsgemäße Schnittstelle mit Anschlüssen, bezüglich vorbekannter Funktionsmodule mit mindestens sechs Anschlüssen (freie Verkabelung erforderlich), zwei oder mehr Anschlüsse eingespart werden können und diese Einsparungen in Gestalt der erfindungsgemäßen Ausnehmung so abgebildet werden, dass die Ausnehmung gerade mit den Vorsprüngen des Schaltgerätes in Eingriff gestellt ist. Hierdurch wird gegenüber einer Anordnung, in der die Ausnehmungen nicht mit den Vorsprüngen des Schaltgerätes in Eingriff gestellt sind, wertvolle Einbautiefe eingespart, und zwar ohne die Größe der Leiterplatte einzuschränken, da die erfindungsgemäße Ausnehmung als Absatz ausgeführt ist. Dadurch, dass die Höhe der Ausnehmung erfindungsgemäß maximal 10 mm, insbesondere weniger als 8 mm, beträgt, wird das Volumen des Funktionsmoduls dabei nur so weit eingeschränkt, wie es erforderlich ist, um den maximalen Einbautiefengewinn zu gewinnen.

Gemäß einer weiteren Ausgestaltung des erfindungsgemäßen Funktionsmoduls weist dieses ein Fixiermittel, beispielsweise ein Kleber, insbesondere ein doppelseitiges Klebeband auf seinem Gehäuse auf.

Gemäß einer weiteren Ausgestaltung des erfindungsgemäßen Funktionsmoduls sind die Anschlüsse benachbart parallel zueinander angeordnet, wobei der Abstand zueinander weniger als 4 mm, insbesondere weniger als 2 mm, beträgt, wobei das Funktionsmodul abgeflachte Seiten aufweist. Hierdurch wird ein besonders einfacher Anschluss von Kabelgut an das Funktionsmodul ermöglicht, wobei eine kompakte Bauform erhalten bleibt.

Nachfolgend ist der Stand der Technik und die Erfindung unter Bezugnahme auf die beigefügten Figuren anhand diverser Ausführungsbeispiele beschrieben. Es zeigen:
- **Fig. 1:**: eine schematische Seitenansicht eines Schaltgerätes in einer flachen Installationsdose,
- **Fig. 2:**: eine schematische Seitenansicht eines Schaltgerätes in einer flachen Installationsdose mit angedeuteten gattungsgemäßen Funktionsmodul,
- **Fig. 3:**: eine schematische Seitenansicht eines Schaltgerätes in einer tiefen Installationsdose mit gattungsgemäßen Funktionsmodul, wobei das Funktionsmodul in Folge einer mechanischen Erschütterung verrutscht,
- **Fig. 4:**: eine schematische Seitenansicht eines Schaltgerätes in einer flachen Installationsdose mit einem erfindungsgemäßen Funktionsmodul, wobei das Gehäuse Ausnehmungen aufweist, die mit Vorsprüngen des Schaltgerätes in Eingriff gestellt sind, und
- **Fig. 5:**: eine perspektivische Seitenansicht des erfindungsgemäßen Funktionsmoduls (links) und eine schematische Draufsicht auf ein erfindungsgemäßes Funktionsmodul (rechts) inklusive der Leiterplatte, wobei der Sensor zur Erfassung des Magnetfeldes zur induktiven Erfassung von Strom und/oder Spannung unmittelbar angrenzend zu den Anschlüssen angeordnet ist.

In den verschiedenen Figuren sind gleiche Teile stets mit den gleichen Bezugszeichen versehen und werden daher in der Regel auch jeweils nur einmal benannt beziehungsweise erwähnt.

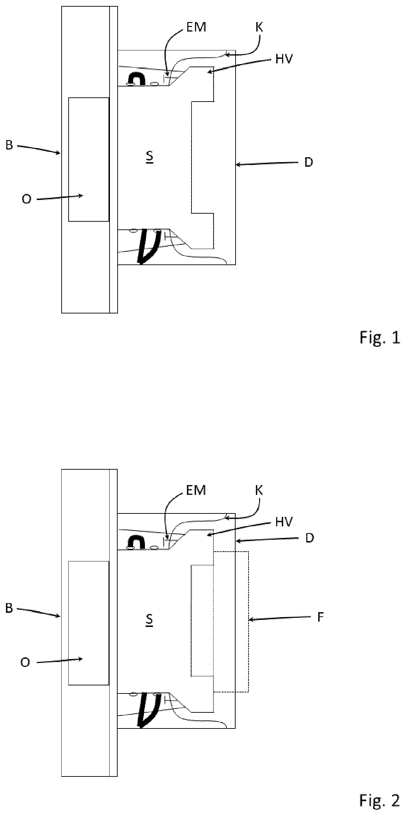

Das in Figur 1 schematisch in einer Seitenansicht dargestellte aus dem Stand der Technik vorbekannte Schaltgerät S ist in einer flachen Installationsdose D angeordnet. Durch Betätigung eines an dem Schaltgerät S angeschlossenen Betätigungselementes B eines Oberteils O des Schaltgerätes S ist das Schaltgerät S beeinflussbar, beispielsweise zum Schalten einer Lampe.

Figur 2 zeigt eine schematische Seitenansicht eines Schaltgerätes S in einer flachen Installationsdose mit angedeuteten gattungsgemäßen Funktionsmodul F, wobei erkennbar ist, dass ein solches Funktionsmodul F aufgrund seiner Dimensionierung bezüglich der Vorsprünge HV des Schaltgerätes S wertvoller Bauraum verschenkt wird. Angedeutet ist, dass das Funktionsmodul F nicht mehr in die Installationsdose D passt, so dass praktisch die Installation eines solchen vorbekannten Funktionsmoduls F nicht durchführbar ist, obwohl dieses attraktive Funktionen, beispielsweise das Dimmen, das Schalten von Verbrauchern, das Steuern von Jalousien oder dergleichen, fernbedienbar bereitstellen würde.

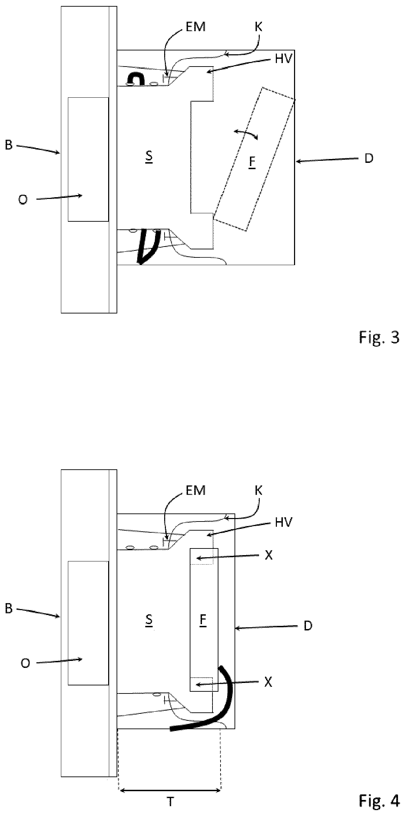

Daher werden in der Praxis solche Funktionsmodule F lediglich in sogenannten tiefen Installationsdosen D eingebaut, siehe Figur 3, die eine schematische Seitenansicht eines Schaltgerätes S in einer tiefen Installationsdose D mit gattungsgemäßen Funktionsmodul F zeigt. Dabei weist das Funktionsmodul F zumindest eine Schnittstelle auf (nicht näher dargestellt), mittels welcher zumindest ein Aktor entsprechend einer Betätigung des Betätigungselements B ansteuerbar ist, wobei an dem Schaltgerät S mindestens ein Magnet M angeordnet ist, welcher bei Betätigung des Betätigungselementes B seine Position ändert. Ferner weist das Funktionsmodul F einen Sensor H zur Erfassung des Magnetfeldes auf, so dass die Änderung des Magnetfeldes bei Betätigung des Betätigungselementes B detektiert wird. Dabei weist das Funktionsmodul F eine Auswerteeinheit zur Auswertung der Magnetfeldänderung auf, die dazu eingerichtet ist, in Abhängigkeit der sensierten Magnetfeldänderung zu identifizieren, um welche Schaltgeräteart es sich bei dem Schaltgerät S handelt, welche Identifikation in die funktionsmodulseitige Ansteuerung des Aktors einfließt. Hierdurch wird es ermöglicht, die Identifikation der Schaltgeräteart durch die Auswerteeinheit vorzunehmen, so dass die Ansteuerung des jeweiligen Aktors auf korrekte Art und Weise vorgenommen wird, ohne, dass ein Austausch des Schaltgerätes S, beispielsweise der Ersatz eines Schalters durch einen Taster, wie es regelmäßig zum Betrieb eines Dimmers nötig ist, erforderlich wäre. Bei einem solchen Funktionsmodul F wird die Betätigung magnetisch detektiert, ohne, dass ein elektrischer Kontakt zwischen Funktionsmodul F und Schaltgerät S gegeben sein muss. Daher ist ein solches vorbekanntes Funktionsmodul F von einem grundsätzlich großen Interesse im Bereich der Gebäudeinstallationstechnik, da der Installationsaufwand überschaubar ist gegenüber Funktionsmodulen F, die über mehrere Kabel (sogenannte fliegende Verkabelung) mit dem Schaltgerät S zu verbinden sind. Problematisch jedoch bleibt der hohe Bauraumbedarf sowie der Aspekt, dass selbst relativ geringe Erschütterungen zu einem Verrutschen beziehungsweise Wackeln eines solchen vorbekannten Funktionsmoduls F führt. Dadurch wird zwischen Magnet M (regelmäßig im beziehungsweise am Oberteil O beziehungsweise Betätigungselement B des Schaltgerätes S angeordnet) und Sensor H zur Erfassung des Magnetfeldes eine Relativbewegung induziert, die zu unerwünschten Fehlebetätigungen führt, da das Funktionsmodul F solche Erschütterungen, die zu einem Verrutschen des Funktionsmoduls F führen, physikalisch nicht unterscheiden kann von einer tatsächlichen Betätigung des Schaltgerätes S und damit des angeschlossenen Verbrauchers. Aufgrund der strengen Bauraum- und Kostenanforderungen, besteht bei dem in den Figuren 1 bis 3 dargestellten Funktionsmodulen F keine Option, die Leistungsaufnahme beziehungsweise den Energiebedarf von an das Funktionsmodul F angeschlossenen Verbrauchern unterputz zu ermitteln, obwohl dieses eine für den Anwender interessante Funktion darstellt.

Zur Lösung des Bauraum- und des Detektionsproblems ist in Figur 4 ein erfindungsgemäßes Funktionsmodul F gezeigt, welches Funktionsmodul F ein Gehäuse G aufweist, welches eine Schnittstelle mit (beispielsweise maximal vier) Anschlüssen aufweist. Die optionale Minimierung der Anzahl der Anschlüsse auf vier wird im Vergleich zu anderen ohne Magnetsensor ausgestatteten Funktionsmodulen F erst möglich, da Anschlüsse für die Verbindung zwischen Funktionsmodul F und Schaltgerät S entfallen. Diesen Aspekt ausspielend, weist das erfindungsgemäße Gehäuse G mindestens eine Ausnehmung X auf, die mit den Vorsprüngen HV des Schaltgerätes S in Eingriff gestellt ist. Solche Vorsprünge HV erstrecken sich regelmäßig in Richtung des Bodens der Installationsdose D und dienen als Haltevorrichtung, in die Schraubdome eingesetzt sind, um die mittels Einstellmitteln EM verstellbaren Spreizkrallen zur Festlegung des Schaltgerätes S an der Installationsdose D sicherzustellen. Durch die mögliche Reduktion der Anzahl der Anschlüsse von mindestens sechs (bei Funktionsmodulen F, die elektrisch mit dem Schaltgerät S verbunden werden) auf vier (beispielhafte erfindungsgemäße Ausführungsform) wird es erreicht, dass das erfindungsgemäße Gehäuse G eine, wie in Figur 4 dargestellt, regelmäßig auch zwei, Ausnehmungen X aufweisen kann, da das benötigte Volumen für die wegfallenden Anschlüsse entfällt. Insofern wird das entfallene Volumen geschickt zur Schaffung mindestens einer Ausnehmung X im Gehäuse G genutzt. Durch das vorteilhafte erfindungsgemäße Ineingriffstellen der mindestens einen Ausnehmung X mit den Vorsprüngen HV des Schaltgerätes S wird es erreicht, dass die effektive Einbautiefe T im Vergleich zu vorbekannten Funktionsmodulen F signifikant verringert wird. Gleichzeitig wird hierdurch eine Positionsfixierung erreicht, die die Stabilität der Detektion von tatsächlichen Betätigungen des Schaltgerätes S gegenüber Erschütterungen, die zu einem Bewegen des Funktionsmoduls F führen, wirksam verbessert. Ferner erlaubt es, das definierte Ineingriffstellen der mindestens einen Ausnehmung X mit den Vorsprüngen HV des Schaltgerätes S eine Vorzugslage zu schaffen, die sich positiv auf das Signal-zu-Rausch-Verhältnis des Sensors H beziehungsweise für die Auswertung der Magnetfeldänderung bezüglich des durch den Magneten M verursachten Magnetfeldes durch die Auswerteeinheit auswirkt. Insofern werden durch das erfindungsgemäße Ineingriffstellen der mindestens einen Ausnehmung X mit den Vorsprüngen HV eine Vielzahl unterschiedlicher Vorteile gleichzeitig erreicht: Die Minimierung des Bauraumbedarfs, die Verbesserung der Detektionsstabilität durch eine Positionsfixierung und das Schaffen einer Vorzugslage zur Optimierung des Signal-zu-Rausch-Verhältnisses. Damit wird das erfindungsgemäße Funktionsmodul F für viele Anwender, insbesondere auch im Altbau, in dem lediglich flache Installationsdosen verbaut werden, interessant, was durch vorbekannte, gattungsgemäße Funktionsmodule F gerade erreicht wird.

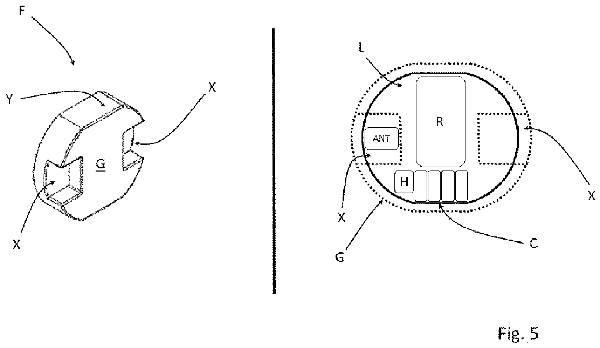

Figur 5 zeigt eine schematische, perspektivische Ansicht eines erfindungsgemäßen Funktionsmoduls F (links) sowie eine schematische Darstellung desselben in einer Draufsicht inklusive der Leiterplatte (rechts). Erkennbar ist, dass das in einer besonders bevorzugten Ausführungsform dargestellte Funktionsmodul F ein Gehäuse G aufweist, das zwei Ausnehmungen X aufweist. Diese sind so ausgebildet, dass sie mit Vorsprüngen HV (regelmäßig zwei Haltevorrichtungen für Schraubdome zur Einstellung der Spreizkrallen K mittels Einstellmitteln EM) des Schaltgerätes S (nicht in Figur 5 dargestellt) in Eingriff zu bringen sind. Dabei macht die mindestens eine Ausnehmung X bezüglich der Grundfläche des Funktionsmoduls F in einer Draufsicht weniger als 50%, insb. weniger als 30%, der Grundfläche aus. Hierdurch wird das Volumen des Funktionsmoduls F auf - hinsichtlich der effektiven Einbautiefe T - besonders effektive Weise verringert. Zur optimalen Einbringung und Ausnutzung des Volumens einer Installationsdose D liegt der Krümmungsradius der Grundfläche des Funktionsmoduls F im Bereich von 18 bis 27 mm, der effektive Durchmesser der Grundfläche des Funktionsmoduls F im Bereich von 32 bis 52 mm, insbesondere im Bereich von 38 mm bis 46 mm. Bezüglich des Vorsehens einer bezüglich der Grundfläche nicht durch die Ausnehmungen X eingeschränkten/verkleinerten Leiterplatte sind die Ausnehmungen X als Absatz mit einer Höhe ausgeführt, wobei die Höhe der Ausnehmung maximal 10 mm, insbesondere weniger als 8 mm, beträgt. Hierdurch wird es ermöglicht, eine möglichst große (durch die Ausnehmung(en) nicht beeinträchtigte) Leiterplattendimensionierung vorzusehen. Bauteile mit einer höheren Höhe (wie beispielsweise Anschlüsse in Gestalt einer Schraub- oder Steckklemme) sind somit in einem Bereich größerer Höhe (außerhalb der Ausnehmung(en) X) anzuordnen. Erfindungsgemäß ist dabei die Schnittstelle geschickt so mit ihren Anschlüssen C auf einer Leiterplatte L angeordnet, dass die Anschlüsse C auf der Leiterplatte L im Bereich außerhalb der Ausnehmung X lokalisiert sind. Hierdurch wird es sichergestellt, dass die Anschlüsse C, regelmäßig als Schraub- oder Steckklemmen ausgeführt, in dem Funktionsmodul F so positioniert sind, dass sie sich nicht negativ auf die effektive Einbautiefe des Funktionsmoduls F auswirken, dessen Ausnehmung(en) X mit Vorsprüngen HV des Schaltgerätes S in Eingriff gestellt ist/sind. Damit stellt der Bereich außerhalb der Ausnehmung X einen Bereich größerer Höhe dar, während ein Bereich innerhalb der Ausnehmung X des Gehäuses G einen Bereich geringerer Höhe darstellt.

Vorliegend ist - wie in Figur 5 (rechts) erkennbar - auf der Leiterplatte L der Bereich außerhalb der Ausnehmungen X für ein Relais R ausgenutzt worden, wodurch die erfindungsgemäß erreichten Bauraumvorteile, insbesondere bezüglich der effektiven Einbautiefe von Funktionsmodul F hinter ein Schaltgerät S, in besonderer Weise ausgenutzt werden. Zudem ist in der dargestellten Ausführungsform der Erfindung auf der Leiterplatte L im Bereich der Ausnehmung X der Sensor H zur Erfassung des Magnetfeldes und/oder eine Funksende- oder Empfangseinheit ANT lokalisiert. Auf diese Art und Weise wird Platz auf der Leiterplatte L geschaffen, um gewisse Aufbauhöhe beanspruchende Bauteile wie Anschlüsse C, Relais R oder Dimmer in Bereichen ohne Ausnehmung X des Gehäuses G anzuordnen (in denen ein gewisser Teil ihrer Aufbauhöhe gewissermaßen zwischen die Vorsprüngen HV des Schaltgerätes S versenkend eintaucht), während der Sensor H zur Erfassung des Magnetfeldes und/oder eine Funksende- oder Empfangseinheit ANT (als Bauteile geringer Aufbauhöhe) im Bereich der Ausnehmung X angeordnet werden.

Bezüglich der kosten- und bauraumneutralen Erfassung der Leistungsaufnahme beziehungsweise des Energiebedarfs von an das Funktionsmodul angeschlossenen Verbrauchern, ist bei dem erfindungsgemäßen Funktionsmodul F der Sensor H zur Erfassung des Magnetfeldes zur induktiven Erfassung von Strom und/oder Spannung unmittelbar angrenzend zu den Anschlüssen C angeordnet. Hierdurch kann es auf besonders kompakte und kostengünstige Art und Weise erreicht werden - der Sensor H zur Erfassung des Magnetfeldes ist ohnehin vorhanden - die Energie- und/oder Leistungsaufnahme angeschlossener Verbraucher zu bestimmen.

Die Erfindung ist anhand von Ausführungsbeispielen beschrieben. Ohne den Umfang der geltenden Ansprüche zu verlassen, ergeben sich für einen Fachmann zahlreiche weitere Möglichkeiten, diese umzusetzen, ohne dass dieses im Rahmen dieser Ausführungen im Einzelnen erläutert werden müsste.

### Bezugszeichenliste

- A: Aufsatz
- ANT: Funksende-/Empfangseinheit
- B: Betätigungselement
- C: Anschluss
- D: Installationsdose
- EM: Einstellmittel
- F: Funktionsmodul
- G: Gehäuse
- H: Sensor
- HV: Vorsprung
- K: Spreizkralle
- L: Leiterplatte
- M: Magnet
- O: Oberteil
- R: Relais

- S: Schaltgerät
- T: Einbautiefe
- X: Ausnehmung
- Y: abgeflachte Seite

## Patentansprüche

1. Funktionsmodul (F) zum Einbau in eine Installationsdose (D) mit einem manuell zu betätigenden Schaltgerät (S) der Gebäudeinstallationstechnik, welches Funktionsmodul (F) durch die Betätigung eines an dem Schaltgerät (S) angeschlossenen Betätigungselementes (B) eines Oberteils (O) des Schaltgerätes (S) beeinflussbar ist, wobei das Funktionsmodul (F) zumindest eine Schnittstelle aufweist, mittels welcher zumindest ein Aktor entsprechend einer Betätigung des Betätigungselements (B) ansteuerbar ist, wobei an dem Schaltgerät (S) mindestens ein Magnet (M) angeordnet ist, welcher bei Betätigung des Betätigungselementes (B) seine Position ändert, und dass das Funktionsmodul (F) einen Sensor (H) zur Erfassung des Magnetfeldes aufweist, so dass die Änderung des Magnetfeldes bei Betätigung des Betätigungselementes (B) detektiert wird, wobei das Funktionsmodul (F) eine Auswerteeinheit zur Auswertung der Magnetfeldänderung aufweist, die dazu eingerichtet ist, in Abhängigkeit der sensierten Magnetfeldänderung zu identifizieren, um welche Schaltgeräteart es sich bei dem Schaltgerät (S) handelt, welche Identifikation in die funktionsmodulseitige Ansteuerung des Aktors einfließt, **dadurch gekennzeichnet, dass** das Funktionsmodul (F) ein Gehäuse (G) aufweist, welches eine Schnittstelle mit Anschlüssen (C) aufweist, wobei der Sensor (H) zur Erfassung des Magnetfeldes zur induktiven Erfassung von Strom und/oder Spannung unmittelbar angrenzend zu den Anschlüssen (C) angeordnet ist.

2. Funktionsmodul nach Anspruch 1, **dadurch gekennzeichnet, dass** das Gehäuse (G) mindestens eine Ausnehmung (X) aufweist, die mit Vorsprüngen (HV) des Schaltgerätes (S) in Eingriff gestellt ist, so dass die effektive Einbautiefe (T) des Funktionsmoduls (F) in der Installationsdose (D) hinter das Schaltgerät (S) verringert und das Funktionsmodul (F) positionsfixiert wird.

3. Funktionsmodul nach einem der Ansprüche 1 oder 2, **dadurch gekennzeichnet, dass** auf der Leiterplatte (L) im Bereich außerhalb der Ausnehmung (X) ein Relais (R) und/oder ein Dimmer lokalisiert ist.

4. Funktionsmodul nach einem der Ansprüche 1 bis 3, **dadurch gekennzeichnet, dass** auf der Leiterplatte (L) im Bereich der Ausnehmung (X) der Sensor (H) zur Erfassung des Magnetfeldes und/oder eine Funksende- oder Empfangseinheit (ANT) lokalisiert ist.

5. Funktionsmodul nach einem der Ansprüche 1 bis 4, **dadurch gekennzeichnet, dass** die mindestens eine Ausnehmung (X) mindestens teilweise komplementär zu den Vorsprüngen (HV) des Schaltgerätes (S) ist.

6. Funktionsmodul nach einem der Ansprüche 1 bis 5, **dadurch gekennzeichnet, dass** es abgeflachte Seiten (Y) aufweist.

7. Funktionsmodul nach einem der Ansprüche 1 bis 6, **dadurch gekennzeichnet, dass** die mindestens eine Ausnehmung (X) bezüglich der Grundfläche des Funktionsmoduls (F) in einer Draufsicht weniger als 50%, insb. weniger als 30%, der Grundfläche ausmacht.

8. Funktionsmodul nach einem der Ansprüche 1 bis 7, **dadurch gekennzeichnet, dass** der Krümmungsradius der Grundfläche des Funktionsmoduls (F) im Bereich von 18 bis 27 mm liegt.

9. Funktionsmodul nach einem der Ansprüche 1 bis 8, **dadurch gekennzeichnet, dass** der effektive Durchmesser der Grundfläche des Funktionsmoduls (F) im Bereich von 32 bis 52 mm, insbesondere im Bereich von 38 mm bis 46 mm, liegt.

10. Funktionsmodul nach einem der Ansprüche 1 bis 9, **dadurch gekennzeichnet, dass** die Ausnehmung (X) als Absatz mit einer Höhe ausgeführt ist, wobei die Höhe der Ausnehmung maximal 10 mm, insbesondere weniger als 8 mm, beträgt.

11. Funktionsmodul nach einem der Ansprüche 1 bis 10, **dadurch gekennzeichnet, dass** die Anschlüsse benachbart parallel zueinander angeordnet sind, wobei der Abstand zueinander weniger als 4 mm, insbesondere weniger als 2 mm, beträgt.

12. Anordnung umfassend ein Funktionsmodul (F) nach den Ansprüchen 1 bis 11 und ein Schaltgerät (S), insbesondere einen Schalter oder einen Taster, wobei das Funktionsmodul (F) mit seinen Ausnehmungen (X) in Eingriff mit den Vorsprüngen des Schaltgerätes (S) gestellt ist.

## Geänderte Patentansprüche

### Geänderte Patentansprüche gemäss Regel 137(2) EPÜ.

1. Anordnung umfassend ein manuell zu betätigendes Schaltgerät (S) der Gebäudeinstallationstechnik sowie ein Funktionsmodul (F) zum Einbau in eine Installationsdose (D), welches Funktionsmodul (F) durch die Betätigung eines an dem Schaltgerät (S) angeschlossenen Betätigungselementes (B) eines Oberteils (O) des Schaltgerätes (S) beeinflussbar ist, wobei das Funktionsmodul (F) zumindest eine Schnittstelle aufweist, mittels welcher zumindest ein Aktor entsprechend einer Betätigung des Betätigungselements (B) ansteuerbar ist, wobei an dem Schaltgerät (S) mindestens ein Magnet (M) angeordnet ist, welcher bei Betätigung des Betätigungselementes (B) seine Position ändert, und dass das Funktionsmodul (F) einen Sensor (H) zur Erfassung des Magnetfeldes aufweist, so dass die Änderung des Magnetfeldes bei Betätigung des Betätigungselementes (B) detektiert wird, wobei das Funktionsmodul (F) eine Auswerteeinheit zur Auswertung der Magnetfeldänderung aufweist, die dazu eingerichtet ist, in Abhängigkeit der sensierten Magnetfeldänderung zu identifizieren, um welche Schaltgeräteart es sich bei dem Schaltgerät (S) handelt, welche Identifikation in die funktionsmodulseitige Ansteuerung des Aktors einfließt, wobei das Funktionsmodul (F) ein Gehäuse (G) aufweist, welches eine Schnittstelle mit Anschlüssen (C) aufweist, wobei der Sensor (H) zur Erfassung des Magnetfeldes zur induktiven Erfassung von Strom oder Spannung unmittelbar angrenzend zu den Anschlüssen (C) angeordnet ist, **dadurch gekennzeichnet, dass** das Gehäuse (G) mindestens eine Ausnehmung (X) aufweist, die mit Vorsprüngen (HV) des Schaltgerätes (S) in Eingriff gestellt ist, so dass die effektive Einbautiefe (T) des Funktionsmoduls (F) in der Installationsdose (D) hinter das Schaltgerät (S) verringert und das Funktionsmodul (F) positionsfixiert wird.

2. Anordnung nach Anspruch 1, **dadurch gekennzeichnet, dass** auf der Leiterplatte (L) im Bereich außerhalb der Ausnehmung (X) ein Relais (R) oder ein Dimmer lokalisiert ist.

3. Anordnung nach einem der Ansprüche 1 bis 2, **dadurch gekennzeichnet, dass** auf der Leiterplatte (L) im Bereich der Ausnehmung (X) der Sensor (H) zur Erfassung des Magnetfeldes oder eine Funksende- oder Empfangseinheit (ANT) lokalisiert ist.

4. Anordnung nach einem der Ansprüche 1 bis 3, **dadurch gekennzeichnet, dass** die mindestens eine Ausnehmung (X) mindestens teilweise komplementär zu den Vorsprüngen (HV) des Schaltgerätes (S) ist.

5. Anordnung nach einem der Ansprüche 1 bis 4, **dadurch gekennzeichnet, dass** es abgeflachte Seiten (Y) aufweist.

6. Anordnung nach einem der Ansprüche 1 bis 5, **dadurch gekennzeichnet, dass** die mindestens eine Ausnehmung (X) bezüglich der Grundfläche des Funktionsmoduls (F) in einer Draufsicht weniger als 50%, insb. weniger als 30%, der Grundfläche ausmacht.

7. Anordnung nach einem der Ansprüche 1 bis 6, **dadurch gekennzeichnet, dass** der Krümmungsradius der Grundfläche des Funktionsmoduls (F) im Bereich von 18 bis 27 mm liegt.

8. Anordnung nach einem der Ansprüche 1 bis 7, **dadurch gekennzeichnet, dass** der effektive Durchmesser der Grundfläche des Funktionsmoduls (F) im Bereich von 32 bis 52 mm, insbesondere im Bereich von 38 mm bis 46 mm, liegt.

9. Anordnung nach einem der Ansprüche 1 bis 8, **dadurch gekennzeichnet, dass** die Ausnehmung (X) als Absatz mit einer Höhe ausgeführt ist, wobei die Höhe der Ausnehmung maximal 10 mm, insbesondere weniger als 8 mm, beträgt.

10. Anordnung nach einem der Ansprüche 1 bis 9, **dadurch gekennzeichnet, dass** die Anschlüsse benachbart parallel zueinander angeordnet sind, wobei der Abstand zueinander weniger als 4 mm, insbesondere weniger als 2 mm, beträgt.
